# EUROPEAN PATENT SPECIFICATION

(11) **EP 0 339 992 B1**
(45) Date of publication and mention of the grant of the patent: **04.08.1993**
(21) Application number: 89304199.6
(22) Date of filing: 27.04.1989
(51) Int. Cl.: C23C 16/26

(54) **Bonding diamond to diamond**
Diamant-Diamantbindung
Liaison diamant-diamant

(30) Priority: 28.04.1988 GB 8810113
(43) Date of publication of application: 02.11.1989
(73) Proprietor: DE BEERS INDUSTRIAL DIAMOND DIVISION (PROPRIETARY) LIMITED, Johannesburg, Transvaal (ZA)
(72) Inventor: Jones, Barbara Lynn, Forest Park Bracknell, RG12 3TX (GB)
(74) Representative: Ellis-Jones, Patrick George Armine

(56) References cited:
- EP-A- 0 251 264
- EP-A- 0 297 845
- WO-A-88/02792
- US-A- 4 074 471
- DERWENT ACCESSION Nr. 83-63 792K Questel Telesystemes (WPIL) DERWENT PUBLICATIONS LTD., London

## Description

### BACKGROUND OF THE INVENTION

This invention relates to bonding diamond to diamond.

Bonded diamond composites such as diamond compacts are well known in the art and consist of a polycrystalline mass of diamond particles bonded into a hard conglomerate, usually in the presence of a second phase. The second phase will typically contain a diamond catalyst or solvent. Diamond compacts are made under conditions of elevated temperature and pressure in the diamond stable region of the carbon phase diagram.

Various methods have been proposed and tried for growing diamond and diamond-like material on diamond seed crystals by chemical vapour deposition (CVD) using gaseous carbon compounds such as hydrocarbons or carbon monoxide. The gaseous carbon compounds may be decomposed by various methods including the use of heat and radio frequency (RF) energy and also by means of microwave energy.

European Patent Publication No. 0264024 describes a method of enveloping a polycrystalline compact of self-bonded particles having a network of interconnecting empty pores dispersed throughout the compact with a continuous coating of titanium nitride or titanium carbide. The titanium nitride or titanium carbide is, in one embodiment, formed by chemical vapour deposition.

EP-A-0297845 which forms part of the state of the art under Article 54(3) EPC for certain contracting states discloses seeding a substrate with diamonds to produce a polycrystalline diamond film. The aim is to grow larger individual particles by this means.

According to the present invention, there is provided a method of producing a diamond product including the steps of providing surfaces on at least two different diamond particles or plates, the surfaces being spaced from one another but sufficiently close to one another such that a diamond or diamond-like bridge can be grown between the surfaces, and growing a diamond or diamond-like bridge between the diamond surfaces by chemical vapour deposition.
Figure 1 illustrates schematically two diamond plates in contact with each other; and
Figure 2 illustrates schematically apparatus suitable for carrying out the method of the invention.

The invention provides a method which creates a bonding diamond or diamond-like bridge between spaced diamond surfaces. This diamond or diamond-like bridge is produced using chemical vapour deposition techniques. Chemical vapour deposition involves creating an atmosphere of a gaseous carbon compound around the surfaces, bringing the temperature of the surfaces to a suitable elevated temperature, typically at least 600°C, and subjecting the gaseous carbon compound to energy of such a nature as to cause the compound to decompose and produce carbon which deposits on the diamond surfaces. As the process continues, so the diamond growth increases, eventually creating the diamond or diamond-like bridge between the surfaces.

The diamond surfaces should be positioned close to each other for otherwise the bridge will not form. Typically, the spacing between the diamond surfaces will not exceed 150 microns (µm) and generally no more than 75 microns (µm).

The diamond surfaces may be surfaces of diamond particles which form part of a bonded polycrystalline diamond mass. Such a polycrystalline diamond mass will have a network of interconnected empty pores dispersed throughout the mass. The creation of diamond or diamond-like bridges between the diamond particles has the effect of filling, at least partially, the empty pores and thereby strengthening the polycrystalline diamond mass. The diamond growth creating the diamond or diamond-like bridges will occur in and at the surface of the mass and will also penetrate the mass to a limited extent. In this manner, it is possible to produce a polycrystalline diamond body which contains no second or bonding phase and which has a diamond content approaching 100% diamond. The bonded polycrystalline diamond mass will typically be that described in United States Patent 4,224,380, and 4,288,248. Another suitable bonded polycrystalline diamond mass is that which is described in British Patent Publication No. 2,158,086, the second phase of which has been removed, for example, by leaching.

The method of the invention can also be used for creating bridges between discrete diamond particles thereby creating a bonded polycrystalline mass. The discrete diamond particles may be of synthetic or natural origin and will typically have a size of less than 500 microns.

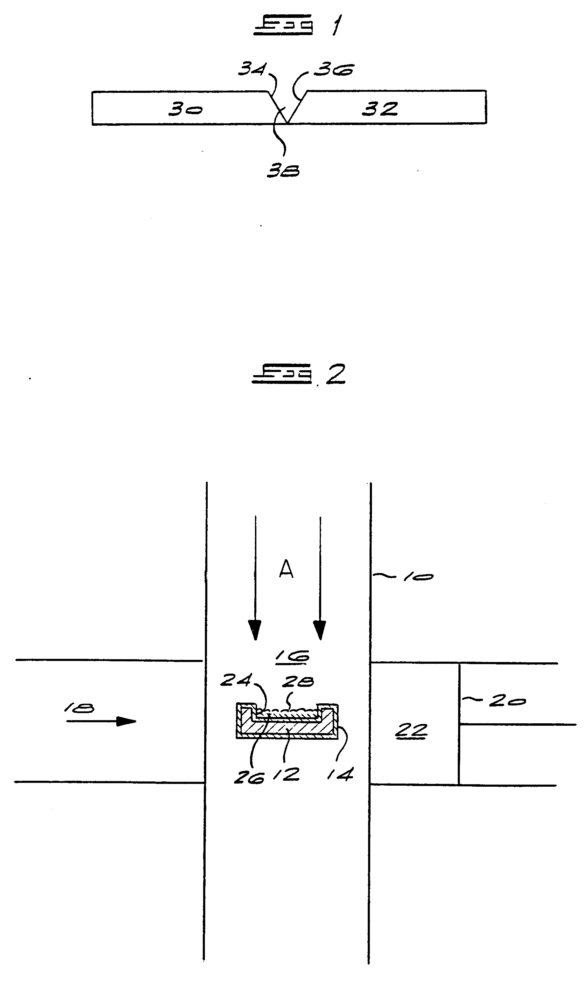

The method of the invention can also be used to produce relatively large diamond plates of good quality. In this form of the invention, diamond plates or particles are provided, each of which may have an outer surface of one of the three well defined planes (100), (110) or (111) or within 3° of any one of these planes. Good crystalline epitaxial diamond growth can be produced on these surfaces. Bridging will occur between adjacent plates. Adjacent plates may have cooperating adjacent surfaces as illustrated by Figure 1. Referring to this Figure, two plates 30, 32 have adjacent end surfaces 34, 36 cut away so that when the two plates are brought together and in contact with each other a V-shaped gap 38 is produced. Diamond growth will occur on the surfaces 34, 36 eventually bridging the gap 38. The surfaces 34, 36 will ideally each be one of the three well defined planes (100), (110) or (111) or within 3° of any one of these planes. It is clear that in some instances the whole of the cavity 38 is filled so that no void remains. The term "bridge" is, of course, intended to cover this situation.

The invention preferably produces a bonding bridge which is crystalline diamond in nature. The method which is used to produce such a bridge includes the steps of placing the diamond surfaces on a suitable nitride surface, creating an atmosphere of gaseous carbon compound around the substrate, bringing the temperature of the nitride surface and the diamond surfaces to at least 600°C, and subjecting the gaseous carbon compound to microwave energy suitable to cause the compound to decompose and produce carbon which deposits on the surfaces and forms crystalline diamond thereon. Essential to this method is that the diamond surfaces are placed on suitable nitride surface.

The nitride surface, during the method, releases nitrogen atoms in small amounts which create a suitable nitrogen concentration in the atmosphere surrounding the diamond surfaces slowing the diamond growth and hence improving it. This nitride surface will generally and preferably cover completely a support which is preferably a microwave energy sink, i.e. a support which will absorb microwave energy and thereby be heated. An example of such a support is a graphite support which will absorb at least 50% of the microwave energy. The nitride may be silicon nitride, aluminium nitride, titanium nitride, tantalum nitride or the like. The nitride surface will typically be formed on a support by means of known chemical vapour deposition methods. Such methods will result in the nitride containing substantial quantities of hydrogen, e.g. 1 to 30 atomic percent. The hydrogen will be strongly bonded. In the case of silicon nitride produced by this method, the nitride will typically have the formula:

SiNₓ.H where x = 0,6 to 1,4.

The temperature of the nitride surface and the diamond surfaces are preferably maintained at a temperature of 600 to 1000°C during the time the decomposition of the carbon compound and deposition of carbon on the diamond surfaces take place. The substrate will generally be at a higher temperature than the nitride surface. The microwave energy which is used to decompose the carbon compound will typically be the source of the heating energy for the surface.

The frequency of the microwave energy may vary over a wide range. Typically the frequency will be in the range 200 MHz to 90 GHz. An example of a typical frequency which may be used is 2,45 GHz. The microwave energy will typically be maintained for a period of at least several hours, e.g. 2 to 10 hours.

The gaseous carbon compound will preferably be introduced into a confined space containing the substrate. The compound may take the form of a mixture with a reducing gas such as hydrogen. Typically, the mixture will contain less than 5% by volume of the carbon compound. The carbon compound will generally be a suitable hydrocarbon such as methane. Examples of other suitable carbon compounds are ethane, propane, fluorinated hydrocarbons such as CF₄, C₂F₆ and CHF₃, carbon monoxide and carbon dioxide.

An embodiment of the invention will now be described with reference to the accompanying drawing. The apparatus consists of a quartz tube 10 in which is suspended one or more graphite boats 12. One graphite boat is illustrated and it has a layer 14 of silicon nitride covering and enclosing its entire outer surface. Microwave energy from a suitable source passes into the space 16 within the tube through the passage 18. A quarter wavelength shorting plate 20 for the microwaves is provided in passage 22. A source of gaseous carbon compound is fed into the space 16 in the direction of arrow A.

Located in the recess 24 of the nitride coated boat 12 is a layer 26 of crystalline silicon on top of which is placed a layer 28 of diamond particles. This arrangement ensures that any movement of the diamond particles is minimised. Most of the diamond crystals make some point contact with an adjacent crystal.

Crystalline diamond growth on the seed crystals was produced by creating microwave energy of 2,45GHz, raising and maintaining the temperature of the graphite boat at 730°C and the diamond seed crystals at a temperature of about 830°C, and introducing gaseous methane gas in admixture with hydrogen gas (the methane gas constituting 5% of the mixture). These conditions were maintained for a period of five hours during which the crystalline diamond growth was such that diamond bridges were produced between a large number of the diamond crystals producing a bonded polycrystalline diamond mass.

## Claims

1. A method of producing a diamond product including the steps of providing surfaces on at least two different diamond particles or plates, the surfaces being spaced from one another but sufficiently close to one another such that a diamond or diamond-like bridge can be grown between the surfaces, and growing a diamond or diamond-like bridge between the diamond surfaces by chemical vapour deposition.

2. A method according to claim 1 wherein the diamond surfaces are surfaces of diamond particles forming part of a bonded polycrystalline diamond mass.

3. A method according to claim 1 wherein the diamond surfaces are surfaces of discrete diamond particles which, when bonded, form a bonded polycrystalline diamond mass.

4. A method according to claim 1 wherein the diamond surfaces are adjacent surfaces on the ends of two diamond plates.

5. A method according to claim 4 wherein the diamond surfaces are each one of the planes or within 3° of any one of these planes.

6. A method according to any one of the preceding claims wherein the spacing between the diamond surfaces (34), (36) is less than 150 µm.

7. A method according to any one of the preceding claims wherein the chemical vapour deposition includes the steps of placing the diamond surfaces on a suitable nitride surface, creating an atmosphere of a gaseous carbon compound around the surfaces, bringing the temperature of the nitride surface and the diamond surfaces to at least 600°C, and subjecting the gaseous compound to microwave energy suitable to cause the compound to decompose and produce carbon which deposits on the surfaces and forms crystalline diamond thereon.

## Patentansprüche

1. Verfahren zur Herstellung eines Diamant-Produkts, umfassend die Schritte des Bereitstellens von Oberflächen auf wenigstens zwei verschiedenen Diamant-Teilchen oder -Platten, wobei diese Oberflächen sich in einem Abstand voneinander, jedoch genügend nahe beieinander, befinden, so daß man eine Diamant- oder diamantartige Brücke zwischen den Oberflächen wachsen lassen kann, und des Wachsenlassens einer Diamant- oder diamantartigen Brücke zwischen den Diamant-Oberflächen durch chemische Abscheidung aus der Dampfphase.

2. Verfahren nach Anspruch 1, worin die Diamant-Oberflächen Oberflächen von Diamant-Teilchen sind, die einen Teil einer verbundenen polykristallinen Diamant-Masse bilden.

3. Verfahren nach Anspruch 1, worin die Diamant-Oberflächen Oberflächen diskreter Diamant-Teilchen sind, die, wenn sie miteinander verbunden werden, eine verbundene polykristalline Diamant-Masse bilden.

4. Verfahren nach Anspruch 1, worin die Diamant-Oberflächen benachbarte Oberflächen auf den Enden zweier Diamant-Platten sind.

5. Verfahren nach Anspruch 4, worin die Diamant-Oberflächen jeweils eine der Ebenen sind oder innerhalb von 3° von irgendeiner dieser Ebenen liegen.

6. Verfahren nach irgendeinen der vorhergehenden Ansprüche, worin der Abstand zwischen den Diamant-Oberflächen (34), (36) kleiner als 150 µm ist.

7. Verfahren nach irgendeinem der vorhergehenden Ansprüche, worin die chemische Abscheidung aus der Dampfphase die Schritte
des Plazierens der Diamant-Oberflachen auf einer geeigneten Nitrid-Oberfläche,
des Schaffens einer Atmosphäre einer gasförmigen Kohlenstoff-Verbindung um die Oberflächen herum,
des Bringens der Temperatur der Nitrid-Oberfläche und der Diamant-Oberflächen auf wenigstens 600 °C, und
des Einwirkenlassens auf die gasförmige Kohlenstoff-Verbindung einer Mikrowellenenergie, die geeignet ist, die Zersetzung der Verbindung zu bewirken und Kohlenstoff zu erzeugen, der sich auf den Oberflächen abscheidet und kristallinen Diamant darauf bildet.

## Revendications

1. Procédé pour la préparation d'un produit de diamant comprenant les étapes consistant à mettre en place des surfaces sur au moins deux plaquettes ou particules de diamant différentes, les surfaces étant espacées l'une de l'autre mais suffisamment proches l'une de l'autre pour permettre la croissance d'un pont ou pontet de diamant ou analogue au diamant entre les surfaces, et à mettre en croissance un diamant ou un pont similaire au diamant entre les surfaces de diamant par déposition en phase gazeuse par procédé chimique.

2. Procédé selon la revendication 1, dans lequel les surfaces de diamant sont des surfaces de particules de diamant faisant partie d'une masse de diamant polycristalline liée.

3. Procédé selon la revendication 1, dans lequel les surfaces de diamant sont des surfaces de particules individuelles de diamant qui, lorsqu'elles sont liées, forment une masse de diamant polycristalline liée.

4. Procédé selon la revendication 1, dans lequel les surfaces de diamant sont des surfaces contiguës sur les extrémités de deux plaquettes de diamant.

5. Procédé selon la revendication 4, dans lequel les surfaces de diamant sont chacune des plans ou à l'intérieur d'une plage de 3° de l'un quelconque de ces plans.

6. Procédé selon l'une quelconque des revendications précédentes, dans lequel l'espacement entre les surfaces de diamant (34), (36) est inférieur à 150 µm.

7. Procédé selon l'une quelconque des revendications précédentes, dans lequel la déposition en phase gazeuse par procédé chimique comprend les étapes consistant à mettre en place les surfaces de diamant sur une surface de nitrure appropriée, à créer une atmosphère de composé de carbone gazeux autour des surfaces, à amener la température de la surface du nitrure et des surfaces de diamant à au moins 600°C, et à soumettre le composé gazeux à une énergie de micro-ondes apte à provoquer la décomposition du composé et à produire du carbone qui se dépose sur les surfaces et y forme un diamant cristallin.
